# EUROPEAN PATENT SPECIFICATION

(11) **EP 3 367 112 B1**
(45) Date of publication and mention of the grant of the patent: **20.04.2022**
(21) Application number: 17157987.3
(22) Date of filing: 24.02.2017
(51) Int. Cl.: G01R 31/52, G01R 31/68, G01R 31/54, H02H 1/00

(54) **MONITORING DEVICE AND METHOD OF MONITORING A MAINS CONNECTION OF AN ELECTRONIC DEVICE**
ÜBERWACHUNGSGERÄT UND METHODE ZUR ÜBERWACHUNG EINER STROMNETZVERBINDUNG EINES ELEKTRONISCHEN GERÄTES
APPAREIL DE SURVEILLANCE ET PROCÉDÉ DE SURVEILLANCE D'UNE CONNECTION D'UN APPAREIL ÉLECTRONIQUE AU RÉSEAU D'ÉLECTRICITÉ

(43) Date of publication of application: 29.08.2018
(73) Proprietor: Vestel Elektronik Sanayi ve Ticaret A.S., 45030 Manisa (TR)
(72) Inventor: ÖZEN, Erol, 45030 Manisa (TR); ÖZKÜCÜK, Serhat, 45030 Manisa (TR)
(74) Representative: Kehl, Ascherl, Liebhoff & Ettmayr Patentanwälte Partnerschaft mbB

(56) References cited:
- FR-A1- 3 010 585
- US-A- 5 434 509
- US-A1- 2005 057 261
- US-A1- 2015 109 077

## Description

### TECHNICAL FIELD

The invention relates to a monitoring device for monitoring a mains connection of an electronic device. The invention further relates to a monitoring method.

### BACKGROUND

Although applicable to any system that comprises a mains connection, the present invention will mainly be described in conjunction with consumer electronics.

Electronics boards of electronic devices that are mains powered usually make electrical contact to the mains outlet via a socket and a cable that is plugged into the socket. There are several socket types such as locked, unlocked, edge sockets and the like. The connection of these sockets and the cables may be provided by users manually or by machines automatically.

In some electronic devices however, the socket connections may be problematic. Problematic in this context means that visually the contact seems to be flawless, but in reality the cable may be inserted into the socket but may not be locked, or poorly contacted or have no contact.

Such situations are hard to detect on the production line because the contact may be sufficiently good during production time. Therefore, a poorly plugged socket in the electronic device may not be detected until the electronic device is installed at a customer's premises.

Such electronic devices with poorly contacted sockets may therefore cause problems because e.g. vibrations during transport may loosen the contact. Poor contact sockets may cause electrical arcs randomly.

Document US 2005 057 261 A1 discloses a method for remotely detecting electric arc events in a power system. Document US 5 434 509 A discloses a method for detecting electric arcing in alternating-current power systems. Document US 2015 109 077 A1 discloses a method for protection of electrical loads from electrical faults. Document FR 3 010 585 A1 discloses a device for electrically protecting electrical conductors.

Accordingly, there is a need for an improved monitoring of the mains connection of electronic devices.

### SUMMARY OF THE INVENTION

The present invention provides a monitoring device with the features of claim 1, a monitoring method with the features of claim 4, and an electrical device with the features of claim 7.

The present invention may e.g. be used to detect the poorly plugged socket connections in consumer electronic products, like e.g. TV sets, set-top boxes, consoles or the like. The present invention may especially be applied to the mains connection of the respective consumer electronic products because electrical arcs or other faults generally occur on the AC or mains connectors. The present invention may also be applied to white goods, like e.g. washing machines, laundry dryers, refrigerators or the like.

Poor of faulty connections on a connector provide two parameters that are monitored according to the present invention. Although other parameters may also be monitored, with the present invention a very simple and effective way of monitoring poor connections in consumer electronic devices is provided.

The first parameter refers to voltage spikes that occur, when an electric arc forms at a faulty or poor connection of a plug and a socket.

The second parameter refers to poor connection based noise on the AC or mains lines.

Tracking of these parameters may be performed on the AC lines, which pass through a socket.

Poorly plugged sockets produce electrical arcs that in turn produce voltage spikes. Such electrical arcs may therefore be detected by the overvoltage detector. In addition, poorly plugged sockets produce noise on the AC or mains lines. This noise is irregular, i.e. it clearly deviates from the noise that is usually present in AC or mains lines. Therefore such noise is clearly detectable.

The signaling unit may already output the warning signal of only the overvoltage or only the abnormal noise is detected. However, the signaling unit may in an alternative only output the warning signal of the overvoltage and the abnormal noise are both detected at the same time.

The warning signal may then be provided e.g. to a user via a display of the electronic device. In addition or as alternative the warning signal may be stored in a memory of the electronic device that may be read out by service personnel. In addition the warning signal may be transmitted e.g. via a network connection to a server, e.g. of the manufacturer of the electronic device.

According to the present invention these two parameters are measured e.g. with the AC signal processing unit. The AC signal processing unit may be any type of unit that is capable of extracting the necessary parameters from the AC or mains lines of the respective electronic device.

The detection of poor connections according to the present invention is sensitive and reliable for socket contacts. In addition this method may also detect damages on the AC supply cable of a consumer electronic device or a wall socket to which the consumer electronic device is plugged in.

Further embodiments of the present invention are subject of the further subclaims and of the following description, referring to the drawings.

In an embodiment, the AC signal processing unit may be configured to permanently measure the voltage and the noise.

Permanently monitoring voltage and noise on the mains connection of a consumer electronic device may require an increased amount of computational power. However, electric arcs may be very short. Permanently monitoring will therefore accurately detect even short arcs.

In an embodiment, the AC signal processing unit may be configured to measure the voltage and measure the noise in predetermined intervals.

If voltage and noise are monitored in intervals, this function may be easily integrated in any other controller or the like, that is already present in the electronic device.

It is understood, that the AC signal processing unit may comprise any analogue or digital element that may be necessary to measure the voltage on the AC or mains lines as well as the noise.

The AC signal processing unit may e.g. comprise a measurement or instrument transformer to transform the mains voltage to a voltage level that may e.g. be handled by an analog-todigital converter e.g. of a microcontroller or the like.

The AC signal processing unit may as an alternative comprise a high impedance voltage divider that produces an output with a voltage level that may e.g. be handled by an analog-todigital converter e.g. of a microcontroller or the like.

It is understood, that at least part of the function of the AC signal processing unit may be provided in an ASIC, a microcontroller or the like.

In another embodiment, the overvoltage detector may comprise a comparator, e.g. an analogue comparator that may be configured to detect an overvoltage if the measured voltage is higher than a predetermined voltage value. The comparator may comprise a configurable comparator that may be adapted to different voltage levels, like e.g. 110 V or 230 V.

As an alternative, the overvoltage detector may comprise an active element, like e.g. a microcontroller, that receives the voltage value from the AC signal processing unit and comprises a firmware that performs the monitoring of the measured voltage according to the preset threshold or voltage value.

It is understood that the overvoltage detector may also be integrated in the AC signal processing unit and both may e.g. be implemented as a firmware or software of a programmable device.

In an embodiment, the AC signal processing unit may comprise a high pass filter element or a band pass filter element configured to attenuate signals with frequencies up to a mains frequency and pass through signals caused by an electric arc with a frequency higher than the mains frequency.

Electric arcs cause a broad spectrum noise that may comprise signal components of up to hundreds of Kilohertz. The specific signal components may depend on the voltage of the mains connection, e.g. 110 V or 230 V or on any other parameter of the electronic device.

The frequency range of the high pass filter or the band pass filter may therefore be determined according to the mains voltage or according to results of experiments conducted with the specific electronic device e.g. during development or production, to identify the relevant frequencies.

A lower cutoff frequency of the filters may e.g. be the mains frequency, e.g. 50 Hz or 60 Hz, especially with an additional safety margin of e.g. 10 Hz, 50 Hz, 100 Hz or the like.

In an embodiment, the AC signal processing unit may comprise a signal processor configured to transform the measured voltage into the frequency domain. Further, the noise detection unit may be configured to analyze the signal levels in a predetermined frequency range of the transformed voltage. The predetermined frequency range may refer to a main frequency range of signals caused by an electric arc or poor connections of e.g. a plug into a socket. The transformation may e.g. be performed with a Fourier Transform, especially with a Fast Fourier Transform.

The transformation into the frequency domain makes obsolete any filter, since the respective or relevant frequency ranges may be directly analyzed for their signal level.

It is understood, that in any case, the relevant monitoring can also be performed in the time domain after filtering out unwanted frequency ranges, i.e. passing through the relevant frequency ranges.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
Fig. 1 shows a block diagram of an embodiment of a monitoring device according to the present invention;
Fig. 2 shows a block diagram of another embodiment of a monitoring device according to the present invention;
Fig. 3 shows a flow diagram of an embodiment of a monitoring method according to the present invention; and
Fig. 4 shows a flow diagram of another embodiment of a monitoring method according to the present invention.

In the figures like reference signs denote like elements unless stated otherwise.

### DETAILED DESCRIPTION OF THE DRAWINGS

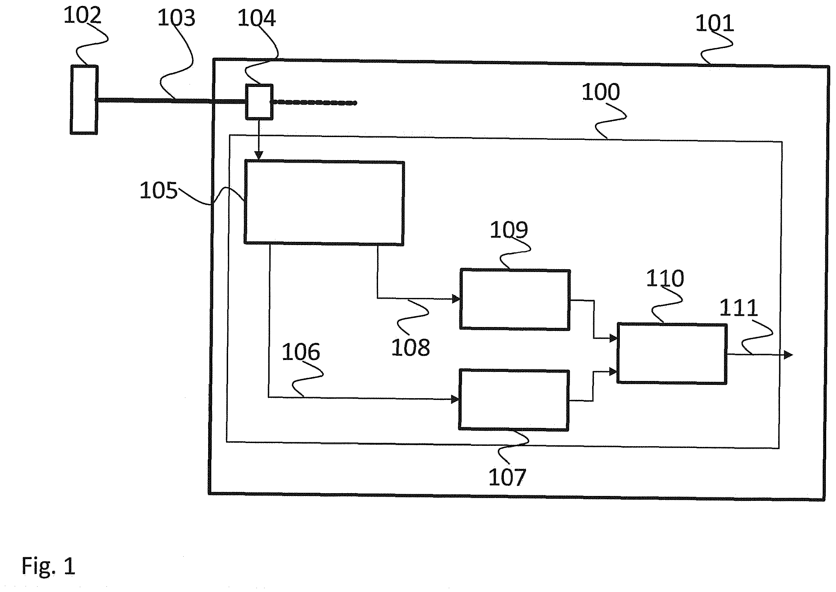

Fig. 1 shows a monitoring device 100 in an electronic device 101. The electronic device 101 is connected via a mains power line 103 to the mains outlet 102. The mains outlet 102 may e.g. provide a voltage of 230 V at a frequency of 50 Hz. The mains power line 103 may e.g. comprise two conductors and in some cases a ground line. The mains power line 103 is connected to a power interface 104 of the electronic device 101. Such a power interface 104 may e.g. be a connector on a circuit board.

The monitoring device 100 comprises an AC signal processing unit 105 that is connected to the power interface 104. The AC signal processing unit 105 is further connected to an overvoltage detector 107 and a noise detection unit 109, which are both coupled to a signaling unit 110.

The AC signal processing unit 105 measures the voltage 106 on the mains connection of the electronic device 101, i.e. the mains power line 103. Further, the AC signal processing unit 105 also measures a noise 108 on the mains connection of the electronic device 101.

The AC signal processing unit 105 may either permanently measure the voltage 106 and the noise 108 or measure the voltage 106 and measure the noise 108 in predetermined intervals.

The information about the measured voltage 106 and the measured noise 108 is then passed on to the overvoltage detector 107 and the noise detection unit 109, respectively.

The overvoltage detector 107 detects an overvoltage in the measured voltage 106, when the measured voltage 106 is higher than a predetermined threshold value. The threshold value may e.g. be 10%, 20%, 30%, 40% or 50% higher than the nominal voltage of the mains system, e.g. 230 V.

The noise detection unit 109 detects abnormal noise 108 on the mains connection.

Finally, the signaling unit 110 outputs a warning signal 111 if the overvoltage detector 107 detects an overvoltage and/or if the noise detection unit 109 detects an abnormal noise 108. It is understood that the signaling unit 110 may output the warning signal 111 only if the overvoltage detector 107 detects an overvoltage and if the noise detection unit 109 also detects an abnormal noise 108 at the same time.

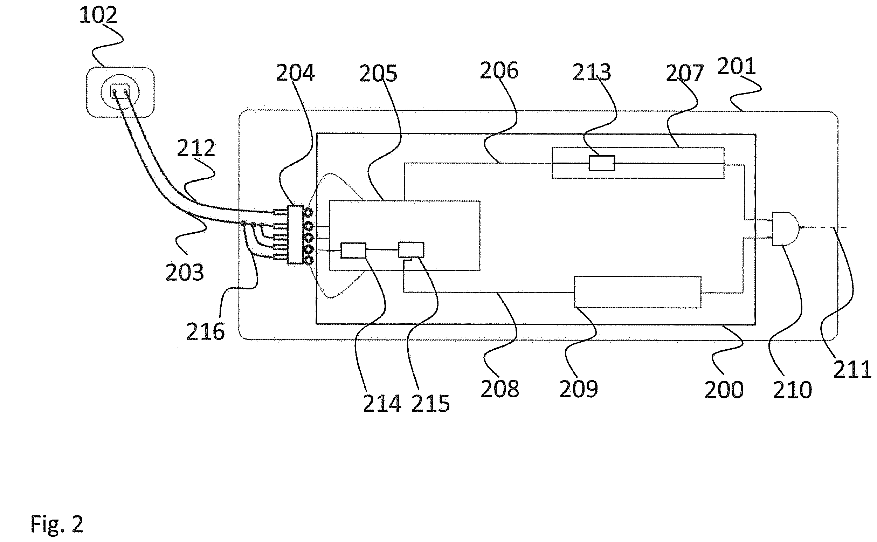

Fig. 2 shows another monitoring device 200 in an electronic device 201. The electronic device 201 is connected via mains power lines 203, 212 to the mains outlet 202. The mains outlet 202 may e.g. provide a voltage of 110 V at a frequency of 60 Hz. The mains power lines 203, 212 are connected to a power interface 204 of the electronic device 201, such as a connector on a circuit board.

The monitoring device 200 also comprises an AC signal processing unit 205 that is connected to the power interface 204. The AC signal processing unit 205 comprises a plurality of connections 216 to the power interface 204. The number of connections 216 may vary from application to application and may depend on the exact internal arrangement of the AC signal processing unit 205 and the sensors or sensing elements used in the AC signal processing unit 205.

The AC signal processing unit 205 is connected to an overvoltage detector 207 and a noise detection unit 209, which are both coupled to a signaling unit 210.

The AC signal processing unit 205 provides an information indicative of the voltage on the mains power lines 203, 212 to the overvoltage detector 207. The overvoltage detector 207 comprises a comparator 213 that will compare the measured voltage 208 to a predetermined threshold value and detect an overvoltage condition, if the measured voltage is higher than the predetermined threshold value. The predetermined threshold value may e.g. be 10%, 20%, 30%, 40% or 50% higher than the nominal voltage of the mains system, e.g. 110 V.

Further, the AC signal processing unit 205 also provides an information indicative of the noise 208 on the mains power lines 203, 212 to the noise detection unit 209.

The AC signal processing unit 205 comprises a high pass filter element 214 or alternatively a band pass filter element, which attenuates signals with frequencies up to a mains frequency and passes through signals caused by an electric arc with a frequency higher than the mains frequency. Further, the AC signal processing unit 205 comprises a signal processor 215 configured to transform the measured voltage 206 into the frequency domain. The noise detection unit 209 can then analyze the signal levels of the transformed voltage 206) in a predetermined frequency range in the frequency domain, e.g. with a simple comparator.

Finally, the signaling unit 210 outputs a warning signal 211 if the overvoltage detector 207 detects an overvoltage and/or if the noise detection unit 209 detects an abnormal noise 208. It is understood that the signaling unit 210 may output the warning signal 211 only if the overvoltage detector 207 detects an overvoltage and if the noise detection unit 209 also detects an abnormal noise 208 at the same time.

For ease of understanding, the reference signs used above in the description of the apparatus-based figures will also be used below in the description of the method based figures.

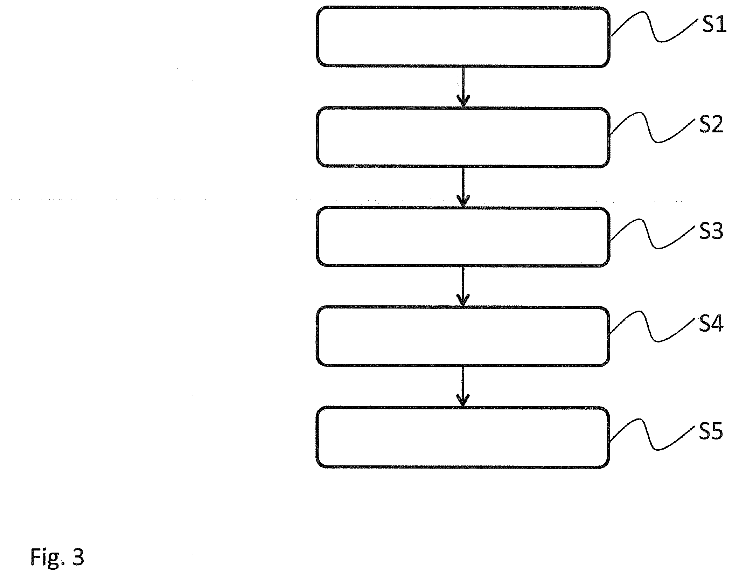

Fig. 3 shows a flow diagram of a monitoring method for monitoring a mains connection of an electronic device 101, 201.

The method comprises measuring S1 a voltage 106, 206 on the mains connection of the electronic device 101, 201. Further, the method comprises measuring S2 a noise 108, 208 on the mains connection of the electronic device 101, 201.

Measuring S1 the voltage 106, 206 and measuring S2 the noise 108, 208 may be permanently performed, e.g. in the background during normal operation of the electronic device 101, 201. As an alternative measuring S1 the voltage 106, 206 and measuring S2 the noise 108, 208 may be performed in predetermined intervals.

In the measured voltage 106, 206 an overvoltage is detected S3, and an abnormal noise 108, 208 is detected S4 on the mains connection, if present.

A warning signal 111, 211 is output S5 if an overvoltage is detected and/or an abnormal noise (108, 208) is detected.

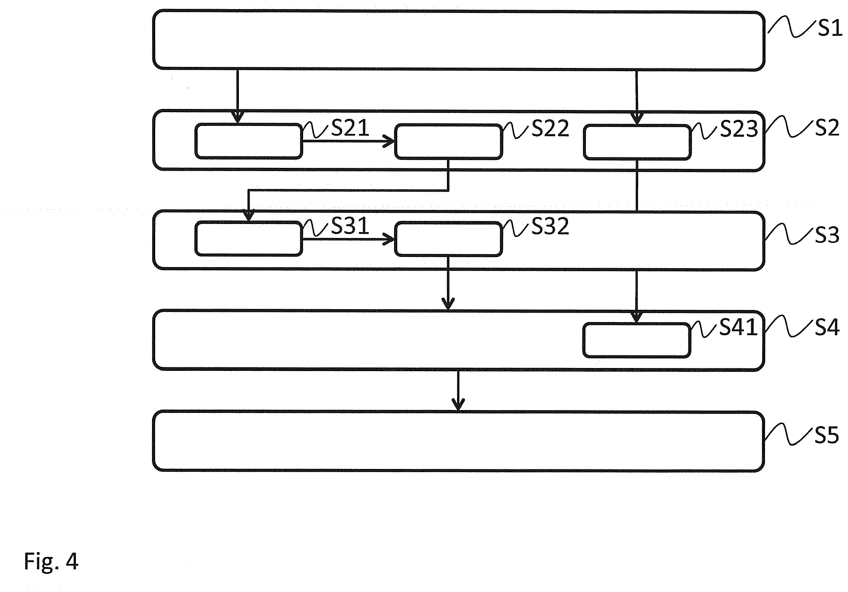

Fig. 4 shows a flow diagram of another embodiment of a monitoring method that is based on the monitoring method of Fig. 3.

The step of detecting S3 an overvoltage in Fig. 4 comprises comparing S31 the measured voltage 106, 206 with a predetermined voltage value or threshold and detecting S32 an overvoltage only if the measured voltage 106, 206 is higher than the predetermined voltage value.

Measuring S2 a noise 108, 208 comprises attenuating S21 signals with frequencies up to a mains frequency and passing S22 through signals caused by an electric arc with a frequency higher than the mains frequency. This takes into account, that electric arcs produce signals with frequencies much higher than the mains frequency and may be detected based on this signals.

Measuring S2 a noise 108, 208 may also comprise transforming S23 the measured voltage 106, 206 into the frequency domain. The step of detecting an abnormal noise S4 then comprises analyzing S41 the signal levels of the transformed voltage 106, 206 in a predetermined frequency range in the frequency domain.

It is understood, that the filtering, attenuating S21 and passing S22, may be performed as alternative to transforming S23, as shown in Fig. 4. As an alternative, the filtered information may be transformed.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims.

The present invention provides a monitoring device 100, 200 for monitoring a mains connection of an electronic device 101, 201, the monitoring device 100, 200 comprising an AC signal processing unit 105, 205 configured to measure the voltage 106, 206 on the mains connection of the electronic device 101, 201 and to measure a noise 108, 208 on the mains connection of the electronic device 101, 201, an overvoltage detector 107, 207 configured to detect an overvoltage in the measured voltage 106, 206, a noise detection unit (109, 209) configured to detect abnormal noise 108, 208 on the mains connection, and a signaling unit 110, 210 configured to output a warning signal 111, 211, if the overvoltage detector 107, 207 detects an overvoltage and/or if the noise detection unit 109, 209 detects an abnormal noise 108, 208. The present invention further provides a respective monitoring method.

**List of reference signs**

| | |
|---|---|
| 100,200 | monitoring device |
| 101, 201 | electronic device |
| 102, 202 | mains outlet |
| 103, 203, 212 | mains power line |
| 104, 204 | interface |
| 105, 205 | AC signal processing unit |
| 106, 206 | voltage |
| 107, 207 | overvoltage detector |
| 108, 208 | noise |
| 109, 209 | noise detection unit |
| 110, 210 | signaling unit |
| 111, 211 | warning signal |
| 213 | comparator |
| 214 | filter element |
| 215 | signal processor |
| 216 | measuring connections |
| S1, S2, S3, S4, S5 | method steps |
| S21, S22, S23 | method steps |
| S31, S32 | method steps |
| S41 | method step |

## Claims

1. Monitoring device (100, 200) for monitoring a mains connection of an electronic device (101, 201), the monitoring device (100, 200) comprising:
an AC signal processing unit (105, 205) configured to measure the voltage (106, 206) on the mains connection of the electronic device (101, 201) and to measure a noise (108, 208) on the mains connection of the electronic device (101, 201), wherein the AC signal processing unit (105, 205) comprises a high pass filter element (214) or a band pass filter element configured to attenuate signals with frequencies up to a mains frequency and pass through signals caused by an electric arc with a frequency higher than the mains frequency,
an overvoltage detector (107, 207) configured to detect an overvoltage in the measured voltage (106, 206) that is produced by voltage spikes that are caused by an electrical arc, and wherein the overvoltage detector (107, 207) comprises a comparator (213) that is configured to detect an overvoltage if the measured voltage (106, 206) is higher than a predetermined voltage value,
a noise detection unit (109, 209) configured to detect abnormal noise (108, 208) on the mains connection, and
a signaling unit (110, 210) configured to output a warning signal (111, 211) if the overvoltage detector (107, 207) detects an overvoltage and/or if the noise detection unit (109, 209) detects an abnormal noise (108, 208).

2. Monitoring device (100, 200) according to claim 1, wherein the AC signal processing unit (105, 205) is configured to permanently measure the voltage (106, 206) and the noise (108, 208) or to measure the voltage (106, 206) and measure the noise (108, 208) in predetermined intervals.

3. Monitoring device (100, 200) according to any one of the preceding claims, wherein the AC signal processing unit (105, 205) comprises a signal processor (215) configured to transform the measured voltage (106, 206) into the frequency domain and wherein the noise detection unit (109, 209) is configured to analyze the signal levels of the transformed voltage (106, 206) in a predetermined frequency range.

4. Monitoring method for monitoring a mains connection of an electronic device (101, 201), comprising:
measuring (S1) a voltage (106, 206) on the mains connection of the electronic device (101, 201),
measuring (S2) a noise (108, 208) on the mains connection of the electronic device (101, 201), wherein measuring (S2) a noise (108, 208) comprises attenuating (S21) signals with frequencies up to a mains frequency and passing (S22) through signals caused by an electric arc with a frequency higher than the mains frequency,
detecting (S3) an overvoltage in the measured voltage (106, 206) that is produced by voltage spikes that are caused by an electrical arc, wherein detecting (S3) an overvoltage comprises comparing (S31) the measured voltage (106, 206) with a predetermined voltage value and detecting (S32) an overvoltage if the measured voltage (106, 206) is higher than the predetermined voltage value, and
detecting (S4) an abnormal noise (108, 208) on the mains connection,
outputting (S5) a warning signal (111, 211) if an overvoltage is detected and/or an abnormal noise (108, 208) is detected.

5. Monitoring method according to claim 4, wherein measuring (S1) the voltage (106, 206) and measuring (S2) the noise (108, 208) is permanently performed or wherein measuring (S1) the voltage (106, 206) and measuring (S2) the noise (108, 208) is performed in predetermined intervals.

6. Monitoring method according to any one of the preceding claims 4 and 5, wherein measuring (S2) a noise (108, 208) comprises transforming (S23) the measured voltage (106, 206) into the frequency domain and wherein detecting (S4) an abnormal noise (108, 208) comprises analyzing (S41) the signal levels of the transformed voltage (106, 206) in a predetermined frequency range.

7. Electronic device comprising:
a monitoring device according to any one of the preceding claims 1 - 3, and
a mains connection with a mains connector.

## Patentansprüche

1. Überwachungsvorrichtung (100, 200) zur Überwachung eines Netzanschlusses einer elektronischen Vorrichtung (101, 201), wobei die Überwachungsvorrichtung (100, 200) aufweist:
eine Wechselstromsignalverarbeitungseinheit (105, 205), die so konfiguriert ist, dass sie die Spannung (106, 206) am Netzanschluss der elektronischen Vorrichtung (101, 201) misst und ein Rauschen (108, 208) am Netzanschluss der elektronischen Vorrichtung (101, 201) misst, wobei die Wechselstromsignalverarbeitungseinheit (105, 205) ein Hochpassfilterelement (214) oder ein Bandpassfilterelement aufweist, das so konfiguriert ist, dass es Signale mit Frequenzen bis zu einer Netzfrequenz dämpft und Signale durchlässt, die durch einen Lichtbogen mit einer Frequenz höher als die Netzfrequenz verursacht werden,
einen Überspannungsdetektor (107, 207), der so konfiguriert ist, dass er eine Überspannung in der gemessenen Spannung (106, 206) detektiert, die durch Spannungsspitzen erzeugt wird, die durch einen elektrischen Lichtbogen verursacht werden, und wobei der Überspannungsdetektor (107, 207) einen Komparator (213) aufweist, der so konfiguriert ist, dass er eine Überspannung detektiert, wenn die gemessene Spannung (106, 206) höher als ein vorgegebener Spannungswert ist,
eine Rauscherkennungseinheit (109, 209), die so konfiguriert ist, dass sie abnormales Rauschen (108, 208) auf dem Netzanschluss erkennt, und
eine Signalisierungseinheit (110, 210), die so konfiguriert ist, dass sie ein Warnsignal (111, 211) ausgibt, wenn der Überspannungsdetektor (107, 207) eine Überspannung feststellt und/oder wenn die Rauschdetektionseinheit (109, 209) ein anormales Rauschen (108, 208) feststellt.

2. Überwachungsvorrichtung (100, 200) gemäß Anspruch 1, wobei die Wechselstromsignalverarbeitungseinheit (105, 205) so konfiguriert ist, dass sie die Spannung (106, 206) und das Rauschen (108, 208) permanent misst oder die Spannung (106, 206) und das Rauschen (108, 208) in vorgegebenen Intervallen misst.

3. Überwachungsvorrichtung (100, 200) gemäß einem der vorhergehenden Ansprüche, wobei die Wechselstromsignalverarbeitungseinheit (105, 205) eine Signalprozessor (215) aufweist, der so konfiguriert ist, dass er die gemessene Spannung (106, 206) in den Frequenzbereich transformiert, und wobei die Rauscherkennungseinheit (109, 209) so konfiguriert ist, dass sie die Signalpegel der transformierten Spannung (106, 206) in einem vorbestimmten Frequenzbereich analysiert.

4. Verfahren zur Überwachung eines Netzanschlusses einer elektronischen Vorrichtung (101, 201), das aufweist:
Messen (S1) einer Spannung (106, 206) am Netzanschluss der elektronischen Vorrichtung (101, 201),
Messen (S2) eines Rauschens (108, 208) am Netzanschluss der elektronischen Vorrichtung (101, 201), wobei das Messen (S2) eines Rauschens (108, 208) ein Dämpfen (S21) von Signalen mit Frequenzen bis zu einer Netzfrequenz und ein Durchlassen (S22) von durch einen Lichtbogen verursachten Signalen mit einer höheren Frequenz als die Netzfrequenz aufweist,
Erfassen (S3) einer Überspannung in der gemessenen Spannung (106, 206), die durch Spannungsspitzen erzeugt wird, die durch einen elektrischen Lichtbogen verursacht werden, wobei das Erfassen (S3) einer Überspannung das Vergleichen (S31) der gemessenen Spannung (106, 206) mit einem vorbestimmten Spannungswert und das Erfassen (S32) einer Überspannung aufweist, wenn die gemessene Spannung (106, 206) höher als der vorbestimmte Spannungswert ist, und
Erfassen (S4) eines anormalen Rauschens (108, 208) auf dem Netzanschluss,
Ausgeben (S5) eines Warnsignals (111, 211), wenn eine Überspannung erkannt und/oder ein anormales Rauschen (108, 208) erkannt wird.

5. Überwachungsverfahren gemäß Anspruch 4, wobei die Messung (S1) der Spannung (106, 206) und die Messung (S2) des Rauschens (108, 208) permanent durchgeführt wird oder wobei die Messung (S1) der Spannung (106, 206) und die Messung (S2) des Rauschens (108, 208) in vorgegebenen Intervallen durchgeführt wird.

6. Überwachungsverfahren gemäß einem der vorhergehenden Ansprüche 4 und 5, wobei die Messung (S2) eines Rauschens (108, 208) eine Transformation (S23) der gemessenen Spannung (106, 206) in den Frequenzbereich aufweist und wobei das Erkennen (S4) eines anormalen Rauschens (108, 208) eine Analyse (S41) der Signalpegel der transformierten Spannung (106, 206) in einem vorbestimmten Frequenzbereich aufweist.

7. Elektronische Vorrichtung, die aufweist:
eine Überwachungsvorrichtung gemäß einem der vorhergehenden Ansprüche 1 - 3, und
einen Netzanschluss mit einem Netzverbinder.

## Revendications

1. Dispositif de surveillance (100, 200) pour surveiller une connexion secteur d'un dispositif électronique (101, 201), le dispositif de surveillance (100, 200) comprenant :
une unité de traitement de signaux CA (105, 205) configurée pour mesurer la tension (106, 206) sur la connexion au secteur du dispositif électronique (101, 201) et pour mesurer un bruit (108, 208) sur la connexion au secteur du dispositif électronique (101, 201), dans laquelle l'unité de traitement de signaux CA (105, 205) comprend un élément de filtre passehaut (214) ou un élément de filtre passe-bande configuré pour atténuer les signaux avec des fréquences jusqu'à une fréquence de secteur et laisser passer les signaux causés par un arc électrique avec une fréquence supérieure à la fréquence de secteur,
un détecteur de surtension (107, 207) configuré pour détecter une surtension dans la tension mesurée (106, 206) qui est produite par des pics de tension qui sont causés par un arc électrique, et dans lequel le détecteur de surtension (107, 207) comprend un comparateur (213) qui est configuré pour détecter une surtension si la tension mesurée (106, 206) est supérieure à une valeur de tension prédéterminée,
une unité de détection de bruit (109, 209) configurée pour détecter un bruit anormal (108, 208) sur la connexion au réseau, et
une unité de signalisation (110, 210) configurée pour émettre un signal d'avertissement (111, 211) si le détecteur de surtension (107, 207) détecte une surtension et/ou si l'unité de détection de bruit (109, 209) détecte un bruit anormal (108, 208).

2. Dispositif de surveillance (100, 200) selon la revendication 1, dans lequel l'unité de traitement du signal CA (105, 205) est configurée pour mesurer en permanence la tension (106, 206) et le bruit (108, 208) ou pour mesurer la tension (106, 206) et mesurer le bruit (108, 208) à intervalles prédéterminés.

3. Dispositif de surveillance (100, 200) selon l'une quelconque des revendications précédentes, dans lequel l'unité de traitement de signal AC (105, 205) comprend un processeur de signal (215) configuré pour transformer la tension mesurée (106, 206) dans le domaine fréquentiel et dans lequel l'unité de détection de bruit (109, 209) est configurée pour analyser les niveaux de signal de la tension transformée (106, 206) dans une plage de fréquence prédéterminée.

4. Méthode de surveillance d'une connexion au secteur d'un dispositif électronique (101, 201), comprenant :
mesurer (S1) une tension (106, 206) sur la connexion secteur du dispositif électronique (101, 201),
mesurer (S2) un bruit (108, 208) sur la connexion au réseau du dispositif électronique (101, 201), dans lequel la mesure (S2) d'un bruit (108, 208) comprend l'atténuation (S21) de signaux avec des fréquences jusqu'à une fréquence de réseau et le passage (S22) de signaux causés par un arc électrique avec une fréquence supérieure à la fréquence de réseau,
détecter (S3) une surtension dans la tension mesurée (106, 206) qui est produite par des pics de tension qui sont causés par un arc électrique, dans lequel la détection (S3) d'une surtension comprend la comparaison (S31) de la tension mesurée (106, 206) avec une valeur de tension prédéterminée et la détection (S32) d'une surtension si la tension mesurée (106, 206) est supérieure à la valeur de tension prédéterminée, et
détecter (S4) un bruit anormal (108, 208) sur la connexion au réseau,
émettre (S5) un signal d'avertissement (111, 211) si une surtension est détectée et/ou un bruit anormal (108, 208) est détecté.

5. Méthode de surveillance selon la revendication 4, dans laquelle la mesure (S1) de la tension (106, 206) et la mesure (S2) du bruit (108, 208) sont effectuées en permanence ou dans laquelle la mesure (S1) de la tension (106, 206) et la mesure (S2) du bruit (108, 208) sont effectuées à intervalles prédéterminés.

6. Méthode de surveillance selon l'une quelconque des revendications précédentes 4 et 5, dans laquelle la mesure (S2) d'un bruit (108, 208) comprend la transformation (S23) de la tension mesurée (106, 206) dans le domaine fréquentiel et dans laquelle la détection (S4) d'un bruit anormal (108, 208) comprend l'analyse (S41) des niveaux de signal de la tension transformée (106, 206) dans une gamme de fréquences prédéterminée.

7. Dispositif électronique comprenant :
un dispositif de surveillance selon l'une quelconque des revendications précédentes 1 - 3, et
une connexion au réseau avec un connecteur de réseau.
